# FASCICULE DE BREVET EUROPEEN

(11) **EP 2 426 712 B1**
(45) Date de publication et mention de la délivrance du brevet: **10.05.2017**
(21) Numéro de dépôt: 11179818.7
(22) Date de dépôt: 02.09.2011
(51) Int. Cl.: H01L 23/482

(54) **Composant électronique planaire de commutation de puissance**
Planares elektronisches Bauelement zur Leistungsumschaltung
Planar power-switching electronic component

(30) Priorité: 03.09.2010 FR 1003528
(43) Date de publication de la demande: 07.03.2012
(73) Titulaire: Thales, 92400 Courbevoie (FR)
(72) Inventeur: Aubry, Raphaël, 91940 GOMETZ LE CHATEL (FR); Jacquet, Jean-Claude, 91400 ORSAY (FR); Delage, Sylvain, 91400 ORSAY (FR)
(74) Mandataire: Esselin, Sophie

(56) Documents cités:
- FR-A1- 2 565 030
- US-A- 6 081 006
- US-A- 6 140 687
- "Field-effect transistor output driver", IBM TECHNICAL DISCLOSURE BULLETIN, INTERNATIONAL BUSINESS MACHINES CORP. (THORNWOOD), US, vol. 28, no. 8, 1 janvier 1986 (1986-01-01), XP002088269, ISSN: 0018-8689

## Description

La présente invention concerne un composant électronique ou micro-électronique de topologie planaire, utilisé à des fins de commutation de puissance.

Pour l'essentiel des utilisations envisagées, le composant électronique planaire selon l'invention a pour fonction de commuter des intensités de puissance élevées, à des fréquences élevées mais inférieures à environ 1 gigahertz.

Ainsi, la présente invention propose une technologie permettant la réalisation de composants planaires pour des applications d'électronique de puissance. L'invention est bien adaptée à la réalisation de composants de commutation de puissance comprenant des substrats conducteurs ou semi-isolants.

Actuellement, dans les dispositifs utilisant des transistors de puissance, comme dans les radars par exemple, les besoins en puissance ne cessent de s'accroître. Par conséquent, pour augmenter la puissance émise par les composants à effet de champ, on cherche aujourd'hui à maximiser la tension et le courant de fonctionnement. L'auto-échauffement des composants, qui découle de cette maximisation de la tension et du courant de fonctionnement, constitue une limite importante car elle entraîne la chute des performances électriques et une dégradation de la fiabilité des composants. L'augmentation de la température de fonctionnement a notamment un impact sur la mobilité électronique, et donc sur les résistances des couches semi-conductrices, sur les résistances de contact métallique, sur les tensions remarquables - tensions de coude, de claquage, et de pincement -, l'ensemble contribuant à une dégradation des rendements électriques. De plus, l'augmentation de la température de fonctionnement accélère la dégradation de la métallurgie des composants, du fait de niveaux d'énergies d'activation pouvant typiquement atteindre 2eV selon des lois du type Arrhenius.

Les composants de puissance de l'état de l'art utilisent des structures verticales, c'est-à-dire des couches épaisses de semiconducteurs, qui permettent un transport électrique perpendiculaire au plan desdites couches. Cela autorise l'obtention de composants relativement compacts. Cependant, cette approche n'est pas bien adaptée à l'utilisation du nitrure de gallium GaN, surtout lorsqu'il est épitaxié sur des substrats constitués de silicium. En effet, il est difficile de faire croître des couches épaisses de GaN sur le silicium du fait des différences entre leurs paramètres de mailles cristallines et leurs coefficients de dilatation thermique respectifs. Il est donc préférable de maintenir la couche de GaN aussi mince que possible, tout en étant compatible de tensions de fonctionnement élevées, pouvant atteindre 1200 volts. Cela implique d'utiliser des composants planaire, et non verticaux. La tenue en tension est obtenue en optimisant la structure du composant, notamment la distance entre l'électrode de grille et l'électrode de drain. Or, par ailleurs, l'utilisation de ces matériaux - GaN sur Si - est privilégiée, pour des raisons économiques, étant donné le coût du substrat - les tailles envisagées pour les composants selon l'invention allant typiquement jusqu'à 200 mm de diamètre - et de compatibilité avec les fonderies silicium actuelles. Or, ceci semble être une condition pratiquement incontournable dans le domaine de l'électronique de puissance, c'est-à-dire avec des tensions atteignant 1200 V, des fréquences de commutation élevées pouvant atteindre plusieurs centaines de MHz, et stabilité thermique attendue jusqu'à 250°C notamment.

Selon l'état de la technique, les composants de puissance classiques, de type transistor à effet de champ - et en particulier les barrettes HEMT, pour High Electron Mobility Transistor selon l'acronyme anglo-saxon -, sont en règle générale constitués de composants élémentaires groupés en parallèles et interconnectés. La puissance injectée dans ces composants provoque une pointe de champ en bout de grille, ainsi qu'un auto-échauffement du composant. Dans ces composants électroniques de commutation de puissance connus, la répartition du champ électrique et de la température ne se fait pas de façon homogène : il existe un gradient longitudinal le long des doigts du transistor, comme cela est connu de l'homme du métier.

Des mesures expérimentales déterminées par spectroscopie Raman, effectuées sur une barrette HEMT de puissance fonctionnant en fréquence RF, et prise comme exemple représentatif de l'état de la technique, montrent un gradient de température transversal à ladite barrette HEMT de puissance, comportant 16 doigts de 250 µm dissipant 3 W/mm à une température de socle de 313 K. Dans le cas considéré, la barrette HEMT était constituée d'un matériau semi-conducteur de grande bande interdite en nitrure de gallium GaN épitaxié sur un substrat de silicium Si. Le gradient de température atteint alors 40 K environ, avec une température centrale d'environ 535 K.

Une solution connue pour faire face aux phénomènes d'auto-échauffement décrits ci-dessus réside dans l'optimisation des distances séparant les composants élémentaires et de la longueur des doigts élémentaires. Une distance infinie entre composants éliminerait les couplages thermiques et l'utilisation de doigts élémentaires infiniment petits éliminerait tout gradient dans le composant élémentaire. Bien évidemment cette approche n'est matériellement pas possible pour des raisons de coût et d'encombrement.

Une autre limitation importante des transistors à effet de champ est liée aux champs électriques intenses présents lorsque des tensions d'alimentation élevées sont appliquées. Or, si des champs élevés sont présents en sortie de grille dans le matériau semi-conducteur, les composants classiques présentent des points particulièrement faibles, des zones de claquage, aux extrémités de la grille. Ces zones de claquage sont attribuées à des phénomènes d'exaltation du champ électrique par effet de pointe.

Ainsi, en électronique de puissance, pour des composants tels que des composants de commutation de puissance, les applications envisagées nécessitent à la fois la maîtrise de tensions de fonctionnement élevées, et des pertes ohmiques faibles.

La présente invention apporte une solution à ces contraintes opposées, dans le cas de composants planaires. En effet, la technologie la plus efficace connue de l'homme du métier consiste à utiliser des composants dits «inter-digités ». Ce type de topologie permet de baisser les résistances ohmiques par une mise en parallèle des doigts, et la tenue en tension est assurée en utilisant des cellules élémentaires compatibles de tensions de fonctionnement élevées, avec cependant des limites liées aux effets de pointes et à la tenue des tensions de fonctionnement maximales.

Les topologies utilisées présentent classiquement des interconnexions sur un niveau - un plan de connexion-, voire deux. L'invention propose d'utiliser des « bus » de connexion sur des plans distincts, de manière à augmenter la compacité des dispositifs, et donc d'abaisser les coûts de production.

Une autre topologie - circulaire ou polygonale - est décrit dans le document US6140687A.

Ainsi, un but de l'invention est notamment de pallier les inconvénients précités. Pour assurer la maîtrise de tensions de fonctionnement élevées tout en minimisant les pertes ohmiques et en contrôlant le phénomène d'auto-échauffement des composants, la présente invention propose une topologie circulaire ou polygonale de composant de commutation de puissance planaire, avec des plans de connexion continus et distincts.

L'invention permet ainsi d'augmenter la compacité des composants, et par voie de conséquence, de réduire les coûts induits par ces composants.

Ainsi l'invention a pour objet un composant électronique planaire de commutation de puissance à haute mobilité électronique selon la revendication 1.

Avantageusement, le composant selon l'invention est un transistor dont la première électrode constitue la grille, la deuxième électrode constitue le drain ou, respectivement, la source, et la troisième électrode constitue réciproquement, la source ou, respectivement, le drain.

Selon un mode de mise en oeuvre, la première couche de métallisation est constituée d'Or ou de Cuivre.

Par ailleurs, la deuxième couche de métallisation peut être constituée d'Or ou de Cuivre.

La couche d'isolant est constituée de l'un des matériaux suivants :
- Un polymère de type « Sol gel » ; ou
- AlN ; ou
- Diamant ; ou
- SiN.

Selon un mode de réalisation, le semi-conducteur utilisé est : GaN.

Le composant de l'invention a typiquement une gamme de fréquence d'utilisation est inférieure à environ 1 GHz.

D'autres caractéristiques et avantages de l'invention apparaîtront à l'aide de la description qui suit faite en regard des dessins annexés qui représentent :
- la figure 1 : la vue générale supérieure d'un HEMT selon l'invention, à une étape intermédiaire de fabrication ;
- la figure 2a : le schéma d'un HEMT circulaire selon l'invention, avec la Source au centre ;
- la figure 2b : le schéma d'un HEMT circulaire selon l'invention, avec le Drain au centre ;
- la figure 3 : la vue schématique d'une coupe transversale d'un HEMT selon l'invention ;
- la figure 4 : le diagramme d'une simulation thermique réalisée pour une dissipation de 10 W/mm pour un HEMT circulaire, selon l'invention

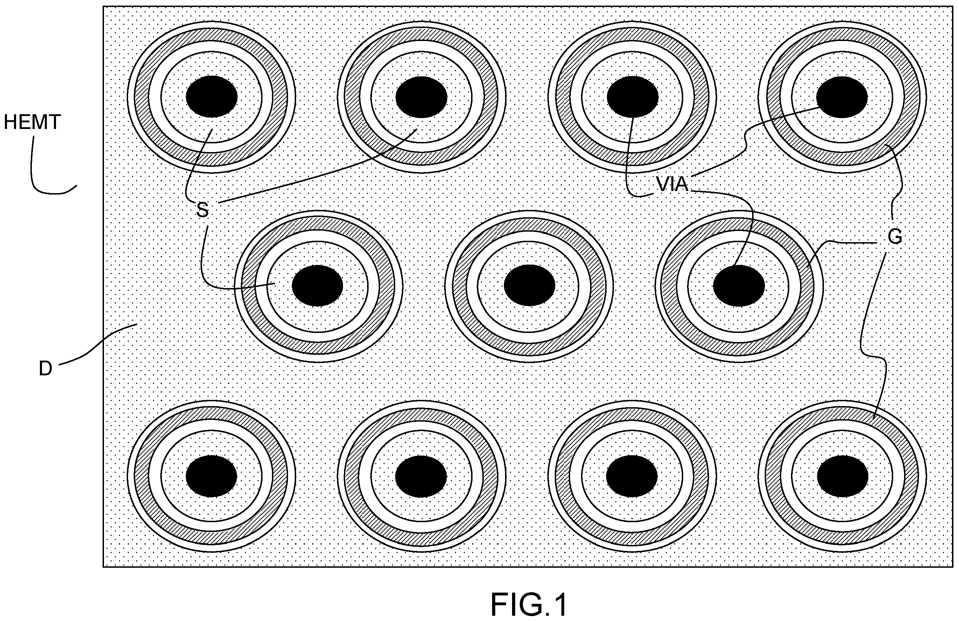

La figure 1 présente un schéma d'un composant planaire de commutation de puissance à haute mobilité électronique selon l'invention.

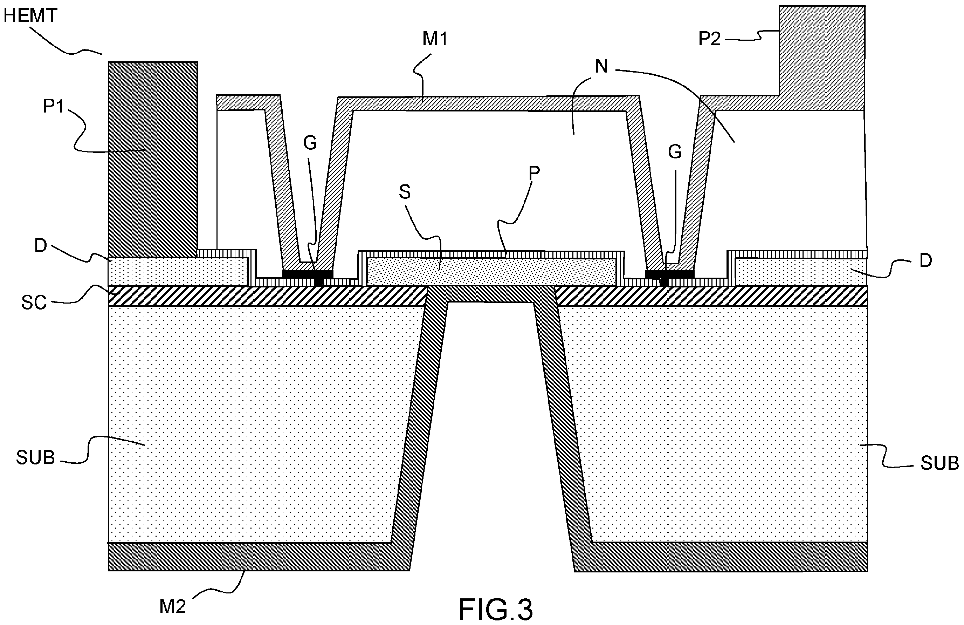

Comme le montre la figure 1, l'invention propose de ne pas utiliser une structure d'interconnexion du type « inter-digitée », adaptée aux composants linéaires classiques. La topologie du composant selon l'invention est fermée, circulaire, comme dans l'exemple de la figure 1, ou polygonale. Plus précisément, sur la figure 1 est représentée la face supérieure du composant selon l'invention. Il s'agit d'une vue générale de la face supérieure d'un HEMT selon l'invention. Cette HEMT comporte des transistors élémentaires de topologie circulaire fermée avec au centre, des sources S formant un disque ; autour de la source S se trouve une couronne assurant la fonction de grille G ; et, occupant la surface restante de ce plan, le drain D. Cette topologie circulaire fermée permet de recourir à des plans métalliques, non représentés, afin de réaliser l'interconnexion des électrodes, comme le montre la figure 3. L'interconnexion entre grilles entre elles G, drains entre eux D et sources entre elles S est ainsi obtenue avec trois plans de métallisation continus, et non des fils ou des bandes, ces plans étant situés sur trois niveaux différents.

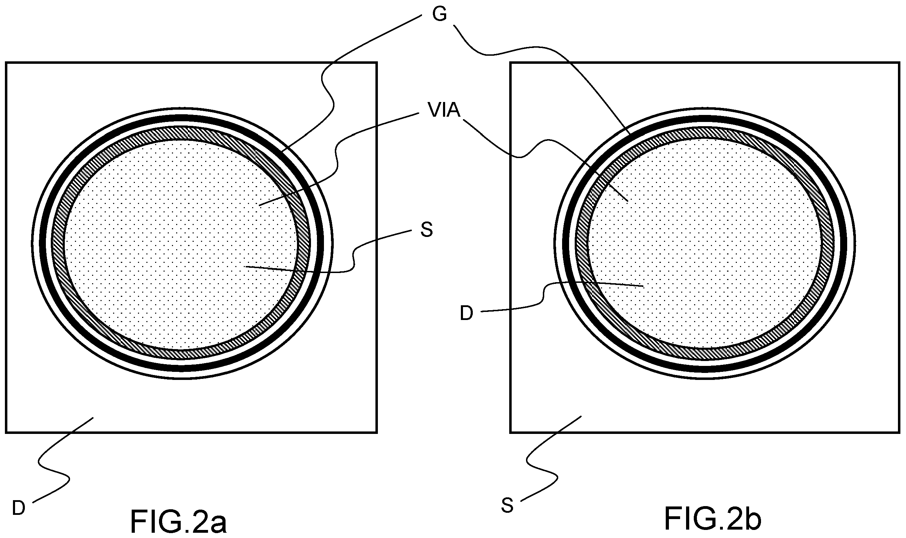

Les figures 2a et 2b illustrent schématiquement deux modes de réalisation possibles de l'invention. Sur la figure 2a, l'électrode-source S est au centre, la couronne assure la fonction de grille G et le plan entourant la grille G constitue le drain D

Sur la figure 2b, l'électrode-drain D est au centre, la couronne assure la fonction de grille G et le plan entourant la grille G constitue la source S.

La figure 3 représente la coupe transversale d'un composant de puissance selon l'invention.

La portion d'HEMT représentée à la figure 3 comprend d'abord un substrat SUB pouvant être constitué de Si ou de SiC recouvert d'une couche de semi-conducteur SC constitué préférentiellement de GaN.

Le principe de ce transistor HEMT est d'avoir un plan de masse situé en face arrière, et constitué d'une couche de métallisation M2 pouvant être de l'Or électrolytique, ou du Cuivre. Les sources S circulaires sont connectées à ce plan de masse M2 grâce à des vias VIA aménagés aux centres des électrodes-sources S, comme représenté à la figure 1.

Le contact de drain D constitue la principale surface du transistor HEMT sur la surface semi-conductrice SC de GaN, avec des ouvertures circulaire qui vont accueillir les sources S et les grilles G concentriques. Il faut noter que, comme indiqué aux figures 2a / 2b, les transistors HEMT peuvent avoir la source S ou le drain D au centre. La source S au centre permet de connecter aisément la source S à la masse constituée par le plan de métallisation M2 en face arrière par l'intermédiaire de vias.

Le composant HEMT selon l'invention comprend de préférence une couche de passivation P, faite sur la totalité de la surface dudit composant HEMT, côté face supérieure. Une ouverture de ce diélectrique P est pratiquée pour le pied de grille G.

Selon l'invention, un isolant N est déposé sur toute la face supérieure du composant HEMT, en dehors du plot de connexions P1 de drain D. Cet isolant peut être constitué d'un polymère de type « sol-gel » qui permet de tenir la tension entre la grille G et la source S ou le drain D, mais peut être aussi un diélectrique de forte conductivité thermique et de forte tenue en tension. Cet isolant N peut ainsi être composé de : AlN ; ou SiN ; ou diamant.

La surface des plaques de champ d'un tel composant HEMT étant importante, une ouverture de l'isolant N est pratiquée sur ces plaques pour la connexion de grille G. Une couche métallisation M1 est par ailleurs appliquée sur la totalité de la face supérieure, exceptée sur le plot d'interconnexion P1 de drain D. Cette couche de métallisation M1 permet l'interconnexion des grilles G, ainsi que leur alimentation par l'intermédiaire d'un plot de connexion P2 de grille G.

Par cet agencement, le composant HEMT selon l'invention comprend donc trois plans de connexion distincts. L'électrode-drain D, conformément à la figure 3, mais il pourrait s'agir de l'électrode-source S dans une autre configuration, constitue un plan de connexion intermédiaire relié à un premier plot de connexion P1 de drain D. Du côté de la face supérieure, le plan de métallisation M1 constitue un plan de connexion supérieur assurant l'interconnexion de grille G ; le plan de métallisation M1 est connecté à un deuxième plot de connexion P2 de grille G. Du côté de la face arrière, le plan de métallisation M2 constitue un plan de connexion arrière formant un plan de masse auquel les électrodes-sources S sont connectées par l'intermédiaire de vias.

Cette solution élimine les lignes coplanaires qui servent généralement à la connexion des drains D entre eux et des grilles G, ainsi que la technologie de pilier pond pour la connexion des sources S entre elles. Elle permet ainsi une optimisation de la surface des composants de commutation de puissance HEMT selon l'invention.

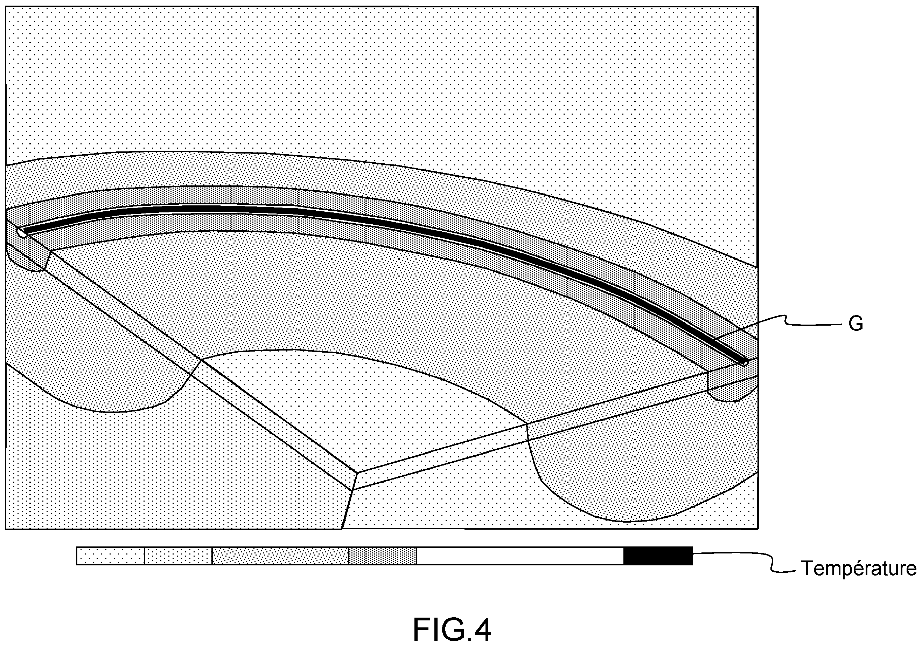

La figure 4 montre que dans un composant HEMT de topologie circulaire ou polygonale, conformément à l'invention, l'évacuation des calories introduites dans ledit composant HEMT se fait avec une symétrie circulaire ou polygonale dans la structure. La répartition de la température possède cette même symétrie.

Un gradient de température existe obligatoirement dans le composant HEMT selon l'invention, mais chaque portion de grille G offre un état thermique identique au matériau semi-conducteur SC sous-jacent. La figure 4 montre une simulation thermique réalisée pour une dissipation thermique de 10 W/mm pour un HEMT circulaire : on constate que la grille G constitue une isotherme.

Par ailleurs, il faut noter que l'amélioration est d'autant plus importante que le développement des composants HEMT est important. De plus, l'utilisation de composants circulaires s'avère favorable thermiquement car la topologie circulaire ou polygonale fermée permet de diminuer la résistance de grille par rapport aux composants linéaires, par un contact répété et équidistant de la grille. Ainsi, l'invention permet d'une part la diminution des températures de fonctionnement, mais aussi d'avoir une température de fonctionnement homogène.

En résumé, l'invention a pour principal avantage de permettre une amélioration des densités de puissance et des rendements de puissance comparativement aux topologies linéaires classiques. Elle implique également un gain en termes de compacité des composants de puissance du type HEMT.

De plus, la topologie proposée facilite le contact ohmique de source / drain, par l'utilisation de vias afin de connecter source / drain à un plan de connexion situé en face arrière.

Enfin, cette invention est particulièrement adaptée aux matériaux « grand gap ».

## Revendications

1. Composant électronique planaire de commutation de puissance à haute mobilité électronique comprenant une pluralité de transistors élémentaires sur un substrat (SUB) recouvert d'une couche de semi-conducteur (SC), lesdits transistors élémentaires comprenant chacun trois électrodes (S,G,D) sur la surface de la couche de semi-conducteur (SC), ledit composant présentant une face supérieure, côté semi-conducteur (SC), et une face arrière, du côté opposé, dans lequel chacun desdits transistors élémentaires présente une topologie fermée circulaire ou polygonale, avec :
• du côté semi-conducteur, une première électrode (G) formant une couronne circulaire ou, respectivement, polygonale,
• au centre de ladite couronne, une deuxième électrode (S, D) formant un disque ou, respectivement, un polygone plein, non jointif de la couronne, et connectée à un plan de connexion arrière par l'intermédiaire de vias (VIA), et
• entourant la couronne, une troisième électrode (D,S) occupant la surface restante de la couche semi-conducteur (SC) et formant une surface quelconque non jointive de ladite couronne,
et dans lequel :
• un isolant (N) est déposé sur le côté semi-conducteur du composant, en dehors d'un second plot de connexion (P1), sa surface plane définissant ladite face supérieure, une ouverture étant pratiquée pour la connexion de ladite première électrode (G)
• ladite première électrode (G) est connectée à un plan de connexion supérieur situé sur la face supérieure, ledit plan étant constitué d'une première couche de métallisation (M1) appliquée sur ladite face supérieure excepté sur le second plot (P1), de manière à former un plan continu de connexion interconnectant lesdites premières électrodes (G) entre elles, ledit plan de connexion supérieur étant alimenté en courant électrique par l'intermédiaire d'un premier plot métallique (P2) et,
• un plan de connexion arrière est situé du côté de la face arrière, et est constitué d'une deuxième couche de métallisation (M2) appliquée sur ladite face arrière de manière à former un plan de masse continu et,
• un plan de connexion intermédiaire (D,S) continu situé entre le plan de connexion arrière et le plan de connexion supérieure constitue ladite troisième électrode (D,S), ledit plan de connexion intermédiaire étant alimenté en courant électrique par l'intermédiaire d'un second plot métallique (P1).

2. Composant électronique planaire de commutation de puissance selon la revendication 1, **caractérisé en ce que** ledit transistor élémentaire est un transistor dont la première électrode constitue la grille (G), la deuxième électrode constitue le drain (D) ou, respectivement, la source (S), et la troisième électrode constitue réciproquement, la source (S) ou, respectivement, le drain (D).

3. Composant électronique planaire de commutation de puissance selon l'une des revendications précédentes, **caractérisé en ce que** la première couche de métallisation (M1) est constituée d'Or ou de Cuivre.

4. Composant électronique planaire de commutation de puissance selon l'une des revendications précédentes, **caractérisé en ce que** la deuxième couche de métallisation (M2) est constituée d'Or ou de Cuivre.

5. Composant électronique planaire de commutation de puissance selon l'une quelconque la revendication 3 ou 4, **caractérisé en ce que** la couche d'isolant (N) est constituée de l'un des matériaux suivants :
• AlN ; ou
• Diamant ; ou
• SiN.

6. Composant électronique planaire de commutation de puissance selon l'une quelconque des revendications précédentes, **caractérisé en ce que** le semi-conducteur (SC) est : GaN.

7. Composant électronique planaire de commutation de puissance selon l'une quelconque des revendications précédentes, **caractérisé en ce que** sa gamme de fréquence d'utilisation est inférieure à environ 1 GHz.

## Patentansprüche

1. Planare elektronische Komponente mit Leistungsumschaltung und hoher Elektronenbeweglichkeit, die mehrere elementare Transistoren auf einem Substrat (SUB) umfasst, das mit einer Halbleiterschicht (SC) bedeckt ist, wobei die elementaren Transistoren jeweils drei Elektroden (S, G, D) auf der Oberfläche der Halbleiterschicht (SC) umfassen, wobei die Komponente eine obere Fläche auf der Halbleiterseite (SC) und eine hintere Fläche auf der gegenüberliegenden Seite hat, wobei jeder der elementaren Transistoren eine geschlossene kreisförmige oder polygonale Topologie hat, mit:
• auf der Halbleiterseite, einer ersten Elektrode (G), die einen kreisförmigen bzw. polygonalen Ring bildet;
• in der Mitte des Rings, einer zweiten Elektrode (S, D), die eine volle Scheibe bzw. ein volles Polygon bildet, die/das nicht an den Ring gefügt und über Durchkontaktierungen (VIA) mit einer hinteren Verbindungsebene verbunden ist; und
• um den Ring herum, einer dritten Elektrode (D, S), die die verbleibende Fläche der Halbleiterschicht (SC) einnimmt und eine Oberfläche bildet, die nicht an den Ring gefügt ist, und wobei:
• ein Isolator (N) auf der Halbleiterseite der Komponente außerhalb einer zweiten Verbindungskontaktstelle (P1) abgesetzt wird, dessen flache Fläche die obere Fläche definiert, wobei eine Öffnung für den Anschluss der ersten Elektrode (G) eingearbeitet ist;
• die erste Elektrode (G) mit einer oberen Verbindungsebene verbunden ist, die sich auf der oberen Fläche befindet, wobei die Ebene von einer ersten Metallisierungsschicht (M1) gebildet wird, die auf die obere Fläche mit Ausnahme der zweiten Kontaktstelle (P1) aufgebracht ist, um eine kontinuierliche Verbindungsebene zu bilden, die die ersten Elektroden (G) untereinander verbindet, wobei die obere Verbindungsebene mit elektrischem Strom durch eine erste metallische Kontaktstelle (P2) gespeist wird; und
• eine hintere Verbindungsebene sich auf der Seite der hinteren Fläche befindet und von einer zweiten Metallisierungsschicht (M2) gebildet wird, die auf die hintere Fläche aufgebracht ist, um eine kontinuierliche Masseebene zu bilden; und
• eine kontinuierliche Zwischenverbindungsebene (D, S), die sich zwischen der hinteren Verbindungsebene und der oberen Verbindungebene befindet, die dritte Elektrode (D, S) bildet, wobei die Zwischenverbindungsebene mit elektrischem Strom durch eine zweite metallische Kontaktstelle (P1) gespeist wird.

2. Planare elektronische Komponente mit Leistungsumschaltung nach Anspruch 1, **dadurch gekennzeichnet, dass** der elementare Transistor ein Transistor ist, in dem die erste Elektrode das Gate (G), die zweite Elektrode den Drain (D) bzw. die Source (S) bildet und die dritte Elektrode die/den jeweils andere(n) aus Source (S) und Drain (D) bildet.

3. Planare elektronische Komponente mit Leistungsumschaltung nach einem der vorherigen Ansprüche, **dadurch gekennzeichnet, dass** die erste Metallisierungsschicht (M1) aus Gold oder Kupfer besteht.

4. Planare elektronische Komponente mit Leistungsumschaltung nach einem der vorherigen Ansprüche, **dadurch gekennzeichnet, dass** die zweite Metallisierungsschicht (M2) aus Gold oder Kupfer besteht.

5. Planare elektronische Komponente mit Leistungsumschaltung nach Anspruch 3 oder 4, **dadurch gekennzeichnet, dass** die Isolierschicht (N) aus einem der folgenden Materialien besteht:
• AIN; oder
• Diamant; oder
• SiN.

6. Planare elektronische Komponente mit Leistungsumschaltung nach einem der vorherigen Ansprüche, **dadurch gekennzeichnet, dass** der Halbleiter (SC) GaN ist.

7. Planare elektronische Komponente mit Leistungsumschaltung nach einem der vorherigen Ansprüche, **dadurch gekennzeichnet, dass** ihr Betriebsfrequenzbereich kleiner als etwa 1 GHz ist.

## Claims

1. A planar power-switching electronic component with high electron mobility, comprising a plurality of elementary transistors on a substrate (SUB) coated with a semi-conductive layer (SC), said elementary transistors each comprising three electrodes (S, G, D) on the surface of said semi-conductive layer (SC), said component having an upper face, on the semi-conductive side (SC), and a rear face, on the opposite side, wherein each of said elementary transistors has a closed circular or polygonal topology, with:
• on the semi-conductive side, a first electrode (G) respectively forming a circular or polygonal ring;
• at the centre of said ring, a second electrode (S, D) respectively forming a solid disc or polygon not abutting the ring and connected to a rear connection plane by means of vias (VIA); and
• surrounding the ring, a third electrode (D, S) occupying the remaining surface of the semi-conductive layer (SC) and forming any surface not abutting said ring,
and wherein:
• an insulator (N) is deposited on the semi-conductive side of the component, outside of a second connection pad (P1), its flat surface defining said upper face, an opening being made to connect said first electrode (G);
• said first electrode (G) is connected to an upper connection plane located on the upper face, said plane being made up of a first metallisation layer (M1) applied to said upper face except on the second pad (P1), so as to form a continuous connection plane interconnecting said first electrodes (G), said upper connection plane being fed with electric current through a first metallic pad (P2); and
• a rear connection plane is located on the side of the rear face and is made up of a second metallisation layer (M2) applied to said rear face, so as to form a continuous ground plane; and
• a continuous intermediate connection plane (D, S) located between the rear connection plane and the upper connection plane forms said third electrode (D, S), said intermediate connection plane being fed with electric current through a second metallic pad (P1).

2. The planar power-switching electronic component according to claim 1, **characterised in that** said elementary transistor is a transistor in which the first electrode forms the gate (G), the second electrode forms one of the drain (D) and the source (S) and said third electrode reciprocally forms the other one of the source (S) and the drain (D).

3. The planar power-switching electronic component according to any one of the preceding claims, **characterised in that** the first metallisation layer (M1) is made up of gold or copper.

4. The planar power-switching electronic component according to any one of the preceding claims, **characterised in that** the second metallisation layer (M2) is made up of gold or copper.

5. The planar power-switching electronic component according to any one of claims 3 or 4, **characterised in that** the insulator layer (N) is made up of one of the following materials:
• AIN; or
• diamond; or
• SiN.

6. The planar power-switching electronic component according to any one of the preceding claims, **characterised in that** the semi-conductive layer (SC) is GaN.

7. The planar power-switching electronic component according to any one of the preceding claims, **characterised in that** its operating frequency range is less than approximately 1 GHz.
